# EUROPEAN PATENT APPLICATION

(11) **EP 4 398 034 A1**
(43) Date of publication of application: **10.07.2024**
(21) Application number: 23150754.2
(22) Date of filing: 09.01.2023
(51) Int. Cl.: G03F 7/00, H01L 21/687

(54) **SUBSTRATE CLAMP LUBRICATION**

(71) Applicant: ASML Netherlands B.V., 5500 AH Veldhoven (NL)
(72) Inventor: KOEVOETS, Adrianus, Hendrik, 5500AH Veldhoven (NL); VAN HAL, Paulus, Albertus, 5500AH Veldhoven (NL); STEL, Bart, Willem, 5500AH Veldhoven (NL); VAN HOUTS, Rens, 5500AH Veldhoven (NL)
(74) Representative: ASML Netherlands B.V.

(57) **Abstract**

A substrate handling system to clamp a substrate is disclosed The system comprises a substrate clamp comprising a plurality of burls comprising respective distal ends, the distal ends forming a substrate support surface configured to support the substrate. The system further comprises a first nozzle configured to output a gas to at least partly surround the burls, and a second nozzle configured to dispense a lubricant into the gas. The lubricant may comprise a hydro carbon containing an acid.

## Description

### FIELD

The present invention relates to a substrate handling system, to a lithographic apparatus comprising such as substrate handling system and to a method of clamping a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate is held by a substrate table, which may be provided with a plurality of burls which form protrusions. Top surfaces of the burls form a substrate carrying surface on which the substrate may be carried. An electrostatic clamp may hold the substate on the burls as the substrate table accelerates, decelerates, etc. High acceleration and deceleration, and a aim to reduce line width of the pattern on the substrate, tends to increase requirements.

### SUMMARY

An object of the present invention is to improve an accuracy of holding of the substrate by the substrate table.

According to an aspect of the invention, there is provided substrate handling system configured to clamp a substrate, comprising:
a substrate clamp comprising a plurality of burls comprising respective distal ends, the distal ends forming a substrate support surface configured to support the substrate;
a first nozzle configured to output a gas to at least partly surround the burls; and
a second nozzle configured to dispense a lubricant into the gas;

According to another aspect of the invention there is provided a lithographic apparatus comprising the substrate handling system according to the present invention.

According to yet another aspect of the invention, there is provided a method of clamping a substrate, comprising:
outputting a gas to at least partly surround a plurality of burls comprising respective distal ends, the distal ends forming a substrate support surface configured to support the substrate,
dispensing a lubricant into the gas; and
clamping the substrate on the distal ends of the burls.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source; and
- Figure 2 depicts a schematic view of a substrate handling system in accordance with an embodiment of the present invention.

### DETAILED DESCRIPTION

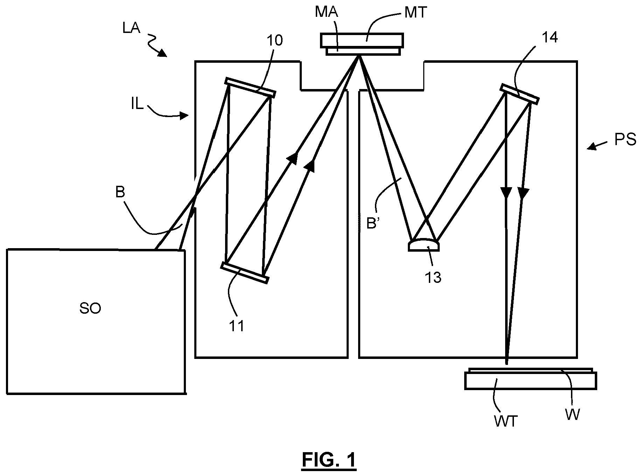

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

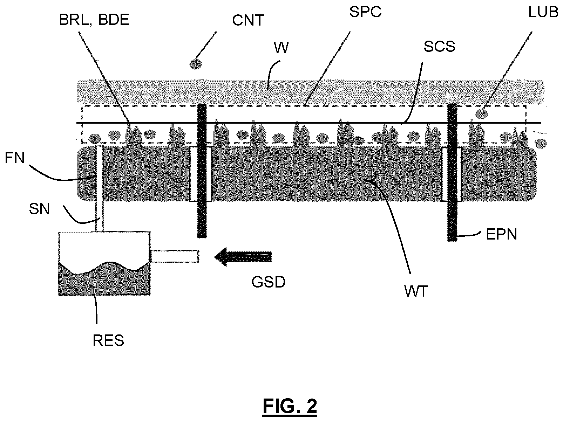

Figure 2 depicts a highly schematic side view of a substrate handling system. The substrate handling system comprises a substrate table WT comprising a plurality of burls BRL. Distal ends BDE of the burls form a substrate carrying surface SCS on which a substrate W may be held. Figure 2 further depicts so called e-pins EPN, forming vertically movable pins actuated by a suitable actuator, in order to load the substrate W on the substrate table and to lift the substrate W from the substrate table for unloading.

Figure 2 further depicts a first nozzle FN which is configured to output a gas in a space SPC surrounding the burls. In the present example, the e-pins carry a substrate, therefore the space SPC being confined by a lower surface of the substrate. The gas supplied by the first nozzle may for example comprise hydrogen gas, H₂. The first nozzle may comprise a gas supply duct which discharges the gas into the space. The substrate table may comprise a clamping device in order to clamp the substrate held by the distal ends of the burls. For example, the clamping device may comprise an electrostatic sheet, to electrostatically clamp the substrate. Accordingly, the substrate table WT may also be identified as a substrate clamp WT.

Due to a loading and unloading of substrates on the burls, edge wear of the burls may occur. During an exposure of the substrate in the lithographic apparatus, the substrate may be heated as a result of the exposure, e.g. as a result of energy absorbed by the substrate during the exposure by Deep Ultra Violet or Extreme Ultra Violet radiation. The (localized) heating may provide for a (localized) thermal expansion of the substrate, which may result in forces on the burls, e.g. lateral forces.

During a loading of the substrate on the burls, an initial warpage of the substrate may cause for example during loading of the substrate that a center of the lower surface of the substrate contacts the burls first, following which the outside of the lower surface contacts the burls. Lateral forces may occur during the loading.

Due to the lateral forces on the burls, edge wear of the burls may occur, while the burls may be heated due to friction effects as may occur during loading, exposure, etc.

According to an aspect of the present invention, the substrate handling system comprises a second nozzle SN configured to dispense a lubricant. The second nozzle is configured to dispense the lubricant into the gas, such as the H₂, supplied by the first nozzle. In the embodiment as depicted in Figure 2, the second nozzle is the first nozzle, which nozzle correspondingly dispenses a mixture of the gas and the lubricant. In order to do so, as reservoir RES may be provided in a gas supply duct GSD of the first nozzle, which reservoir is partially filled with lubricant, in order to mix some lubricant into the gas supplied via the gas supply duct. In another embodiment, the first nozzle and second nozzle may e.g. be adjacent to provide adjacent streams of gas and lubricant to mix with each other. In yet another embodiment, the second nozzle may dispense the lubricant into a duct of the first nozzle, to enable the first nozzle to output the gas with lubricant. In a further embodiment, the second nozzle may be downstream of the first nozzle, to dispense lubricant into a stream of gas output by the first nozzle.

As the lubricant is dispensed into the gas, the lubricant may be carried by the gas to the burls, as the gas output by the first nozzle flows into the space between the burls. Accordingly, the lubricant may be distributed with the gas towards the burls, so as to be able to distribute the lubricant over the burls.

The lubricant may comprise a hydro carbon comprising an acid, such as a hydrocarbon comprising an acid group, such as a fatty acid. Examples of the lubricant comprise an alcohol such as IPA propane-1-ol. It is noted that an acid anchor-group of the lubricant is especially effective in combination with metal-oxide. An extra hydroxyl group on the fatty acid may be beneficial for crosslinking, an example being alfa-hydroxy palmitic acid. It is further noted that a chain-length of the hydrocarbon may be relevant, for example the chain length being associated with lubricating properties of the lubricant. The burls may comprise a metal composition, such as CrN. The acid of the lubricant (such as an acid group of the hydro carbon) may be attracted by the metal comprised in the burls. For example, an interaction between diploes of the acid and an oxide of the metal comprised in the burls may interact to absorb the lubricant on the burls. Due to the interaction between the dipoles, the lubricant may remain on the metal oxide of the burls for a relatively long time, thereby at least partly preventing loss of the lubricant from the burls during the loading of the substrate. On the other hand, the fatty acids will to a much lesser extent interact with a dielectric material of the electrostatic clamp, hence being released from the electrostatic clamp within a relatively short time. At the time of activation of the electrostatic clamp by applying an electrostatic potential to electrostatically clamp the substrate, the lubricant may have released from the electrostatic clamp to a large extent. Furthermore, the relatively short time during which the lubricant remains on the electrostatic clamp, may promote to remove trapped charge in the dielectric material: This is expected to drastically reduce residual charges. Due to lower adoption energy of the acid on the dielectric the monolayer hence surface conductivity of the dielectric may be away at the moment the dielectric clamp is switched on..

As a result, the lubricant may form a thin lubrication layer specifically on the burls, as the acid of the lubricant may interact with the metal of the burls, enabling the hydrocarbon of the lubricant to extend from the surface of the burls to provide lubricating properties during the loading of the substrate. As the lubricant may interact with the dielectric material of the electrostatic clamp to a lesser extent, retaining of the lubricant on the electrostatic clamp may be low, which may reduce or prevent a surface conductivity on the electrostatic clamp due to the acid of the lubricant.

The dispensing of the lubricant into the gas, enabling to relatively evenly dispense the lubricant to the burls, in combination with the acid comprised in the lubricant, enabling the lubricant to form a thin lubrication layer attached to a surface of the burls, may provide for a thin layer of lubrication on the burls. Friction and wear of the burls may be reduced. The lubricant may prevent a direct atomic contact between the burls and the substrate, i.e. the lower surface of the substrate. The distal ends of the burls may be lubricated by a thin layer of the lubricant, whereby the acid, such as the acid group, of the lubricant interacts with the metal enabling the hydrocarbon of the lubricant to interact with the lower surface of the substrate.

In an embodiment, the second nozzle is configured to dispense the lubricant in the first nozzle. The first nozzle may provide for a flow of the gas into the space surrounding the burls. The second nozzle may for example dispense the lubricant in a gas supply duct of the first nozzle, enabling the lubricant to be discharged into the space surrounding the burls by the flow of the gas, providing for a relatively even distribution of the lubricant to the burls within a relatively short time frame. In an embodiment, the first and second nozzles are combined into a single nozzle, thus the second nozzle being the first nozzle to provide a compact implementation to dispense the lubricant with the gas.

In an embodiment, the substrate handling system is configured to dispense the lubricant when the substrate is held above the substrate support surface. The substrate may thereby create an at least partially confined space, at least partially confined by the substrate table with the burls at the lower side of the space and the substrate table at the upper side of the space, enabling to confine the gas supplied by the gas supply system in the at least partly confined space, thereby discharging the lubricant, with the gas, locally at the burls. A contamination of a remainder of the substrate handing system by particles of the lubricant, as symbolically indicated in Figure 2 by contamination CNT formed by a small droplet of the lubricant, may be avoided, or may be reduced, as the lubricant, symbolically indicated in Figure 2 by a small droplet of lubricant LUB , is confined or at least partly confined below the substrate held above the substate support surface.

For example, the substrate handling system may be configured to dispense the lubricant when the substrate is held between 1 mm and 3 mm above the substrate support surface, thereby providing sufficient volume of space for the lubricant to distribute among the burls.

In an embodiment, the substrate handling system is configured to dispense the lubricant in a space under the substrate support surface. For example, the lubricant may be dispensed into the space SPC in which the burls extend, i.e. in the space surrounding the burls. Thereby, a distribution of the lubricant may be confined, to a large extent, to the burls, thereby preventing a contamination of a remainder of the substrate handling system and/or a top surface of the substrate, by the lubricant..

In an embodiment, the substrate handling system is configured to dispense the lubricant during less than 1 seconds, preferably less than 0,6 seconds, more preferably 0.5 seconds. The lubricant may for example be dispensed each time a substrate is loaded onto the substrate clamp. In order to keep a throughput of substrates high, e.g. in a lithographic apparatus, it is desired to load and unload the substrates in a relatively short time. The above mentioned times of dispensing the lubricant

In an embodiment, the substrate handling system is configured to supply the lubricant at a pressure below 10 mPa, preferably below 2 mPa, more preferably 1 mPa. A relatively minor amount of the lubricant may be provided, which on the one hand may be sufficient to lubricate the burls, however on the other hand may prevent a spread of the lubricant causing excessive contamination.

In an embodiment, the substrate handling system is configured to pause a loading of the substrate during dispensing of the lubricant. Preferably, the pausing is performed when the substrate is held above the burls, to form an at least partly confined space. The gas with the lubricant may hence flow through the space at least partially confined by the substrate, so as to enable the burls to be covered by the lubricant before supporting the substrate on the burls.

In an embodiment, the substrate handling system is configured to dispense the lubricant before applying an electrostatic clamping voltage to electrostatically clamp the substrate. As the acid may provide a low interaction with a dielectric material of the electrostatic clamp, the lubricant may be released from the electrostatic clamp within a relatively short time. At the time of activation of the electrostatic clamp by applying an electrostatic potential to electrostatically clamp the substrate, the lubricant may have released from the electrostatic clamp to a large extent, hence surface conductivity of the dielectric may be away at the moment the dielectric clamp is switched on.

In an embodiment, the lubricant comprises a fatty acid. As explained above, the acid group of the fatty acid may interact with the metal so as to bond to the metal of the burls, while the hydrocarbon structure of the fatty acid may provide for lubricating interaction with the lower surface of the substrate. Some examples of suitable hydrocarbons include a straight hydrocarbon chain, typically longer that 8 , ranging from aspelargonic acid with 9 carbons and 17 hydrogen molecules. to C18 stearic acid. Hydrocarbon chains with a length in excess of 18 may become non-beneficial as they may e.g. cause more carbon contamination with the same residence time on the surface of the burls governed by the acid group and the metal oxide.

In an embodiment, the substrate handling system is configured to provide boundary lubrication at the substrate support surface of the burls. The boundary lubrication may provide for a very thin layer of lubrication on the burls, thereby at least partly preventing an atomic contact between the burls and the lower surface of the substrate. As a result, wear of the burls may at least be reduced, while applying only a small amount of the lubricant, hence reducing contamination by the lubricant to a large extent.

The substrate handing system may be comprised in a lithographic apparatus, such as the lithographic apparatus described with reference to Figure 1. With each loading of a substrate, the lubricant may be dispensed, hence providing a small amount of the lubricant to the surface of the burls of the substrate handling system, each time a substrate is loaded onto the burls.

According to a further aspect of the invention, there is provided a method of clamping a substrate, comprising:
outputting a gas to at least partly surround a plurality of burls comprising respective distal ends, the distal ends forming a substrate support surface configured to support the substrate;
dispensing a lubricant into the gas; and
clamping the substrate on the distal ends of the burls.

In an embodiment, the lubricant comprises a hydro carbon containing an acid. The dispensing of the lubricant into the gas, enabling to relatively evenly dispense the lubricant to the burls, in particular in combination with the acid comprised in the lubricant, enabling the lubricant to form a thin lubrication layer attached to a surface of the burls, may provide for a thin layer of lubrication on the burls. Friction and wear of the burls may be reduced. The lubricant may prevent a direct atomic contact between the burls and the substrate, i.e. the lower surface of the substrate. The distal ends of the burls may be lubricated by a thin layer of the lubricant, whereby the acid, such as the acid group, of the lubricant interacts with the metal enabling the hydrocarbon of the lubricant to interact with the lower surface of the substrate.

In an embodiment, the gas is supplied by a first nozzle, the method comprising dispensing the lubricant in the first nozzle.

As explained above, The first nozzle may provide for a flow of the gas into the space surrounding the burls, enabling the lubricant to be discharged into the space surrounding the burls by the flow of the gas, providing for a relatively even distribution of the lubricant to the burls within a relatively short time frame.

In an embodiment the method comprises dispensing the lubricant when the substrate is held above the substrate support surface. The substrate may be lowered to be carried by the burls after the lubricant has been dispensed.

As explained above, the substrate held above the burls may create an at least partially confined space, at least partially confined by the substrate table with the burls at the lower side of the space and the substrate table at the upper side of the space, enabling to confine the gas supplied by the first nozzle in the at least partly confined space, thereby discharging the lubricant, with the gas, locally at the burls. A contamination of a remainder of the substrate handing system by particles of the lubricant may be avoided, or may be reduced, as the lubricant is confined or at least partly confined below the substrate held above the substate support surface.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. A method of clamping a substrate, comprising:
   outputting a gas to at least partly surround a plurality of burls comprising respective distal ends, the distal ends forming a substrate support surface configured to support the substrate,
   dispensing a lubricant into the gas; and
   clamping the substrate on the distal ends of the burls.
2. The method according to example 1, wherein the lubricant comprises a hydro carbon containing an acid.
3. The method according to example 1 or 2, wherein the gas is supplied by a first nozzle, the method comprising dispensing the lubricant in the first nozzle.
4. The method according to any one of examples 1-3, comprising dispensing the lubricant when the substrate is held above the substrate support surface.

## Claims

1. A substrate handling system configured to clamp a substrate, comprising:
a substrate clamp comprising a plurality of burls comprising respective distal ends, the distal ends forming a substrate support surface configured to support the substrate;
a first nozzle configured to output a gas to at least partly surround the burls; and
a second nozzle configured to dispense a lubricant into the gas.

2. The method according to claim 1, wherein the lubricant comprises a hydro carbon containing an acid.

3. The substrate handling system according to claim 1 or 2, wherein the second nozzle is configured to dispense the lubricant in the gas supply system.

4. The substrate handling system according to any one of the preceding claims, wherein the substrate handling system is configured to dispense the lubricant when the substrate is held above the substrate support surface.

5. The substrate handling system according to claim 4, wherein the substrate handling system is configured to dispense the lubricant when the substrate is held between 1 mm and 3 mm above the substrate support surface.

6. The substrate handling system according to any one of the preceding claims, wherein the substrate handling system is configured to dispense the lubricant in a space under the substrate support surface.

7. The substrate handling system according to any one of the preceding claims, wherein the substrate handling system is configured to dispense the lubricant during less than 1 seconds, preferably less than 0.6 seconds, more preferably 0.5 seconds.

8. The substrate handling system according to any one of the preceding claims, wherein the substrate handling system is configured to dispense the lubricant at a pressure below 10 mPa, preferably below 2 mPa, more preferably 1 mPa.

9. The substrate handling system according to any one of the preceding claims, wherein the substrate handling system is configured to pause a loading the substrate during dispensing of the lubricant.

10. The substrate handling system according to any one of the preceding claims, wherein the substrate handling system is configured to dispense the lubricant before applying an electrostatic clamping voltage to electrostatically clamp the substrate.

11. The substrate handling system according to any one of the preceding claims, wherein the lubricant comprises a fatty acid.

12. The substrate handling system according to any one of the preceding claims, configured to provide boundary lubrication at the substrate support surface of the burls.

13. The substrate handling system according to any one of the preceding claims wherein the first nozzle is the second nozzle.

14. A lithographic apparatus comprising the substrate handing system according to any one of the preceding claims.

15. A method of clamping a substrate, comprising:
outputting a gas to at least partly surround a plurality of burls comprising respective distal ends, the distal ends forming a substrate support surface configured to support the substrate,
dispensing a lubricant into the gas; and
clamping the substrate on the distal ends of the burls.
